# EUROPEAN PATENT APPLICATION

(11) **EP 4 531 076 A1**
(43) Date of publication of application: **02.04.2025**
(21) Application number: 24199690.9
(22) Date of filing: 11.09.2024
(51) Int. Cl.: H01L 21/285, H10D 64/64, H10D 8/60, H10D 62/832, H10D 62/10

(54) **FORMING A SCHOTTKY CONTACT IN AN ELECTRONIC DEVICE, SUCH AS A JBS OR MPS DIODE, AND ELECTRONIC DEVICE WITH SCHOTTKY CONTACT**

(30) Priority: 27.09.2023 IT 202300019941
(71) Applicant: STMicroelectronics International N.V., 1228 Plan-les-Ouates, Geneva (CH)
(72) Inventor: BELLOCCHI, Gabriele, 95124 CATANIA (IT); RASCUNA', Simone, 95129 CATANIA (IT); PUGLISI, Valeria, 95125 CATANIA (IT); BADALA', Paolo, 95024 ACIREALE (CT) (IT)
(74) Representative: Studio Torta S.p.A.

(57) **Abstract**

Method of forming a metal-semiconductor Schottky contact, comprising the steps of: forming, on a semiconductor body (22, 24) having a first electrical conductivity (N), a first metal layer (32); performing a thermal treatment of at least a portion of the first metal layer (32) by a LASER beam (42) having an incidence direction (Z) on the first metal layer (32), including heating the portion of the first metal layer (32), along said incidence direction, at a temperature between 1500 °C and 3000 °C.

## Description

### Technical field

The present invention relates to a method of forming a metal-semiconductor Schottky contact, and an electronic device including the metal-semiconductor contact.

### Background art

In the past, many studies have been conducted on the resistance to surge currents of silicon carbide, SiC, diodes. Today, new power applications require better performances in terms of the ability to withstand surge currents. The latter, together with the high leakage current at high temperature, represents the main limitation of pure Schottky diodes. Therefore, the best compromise for high-voltage diodes is represented by Junction Barrier Schottky (JBS) or Merged-PN-Schottky (MPS) devices. This combination has a beneficial effect on the peak current capability because the bipolar activation limits the voltage drop across the diode and therefore limits the power dissipation. Controlling the Schottky Barrier Height (SBH) is fundamental to the performances of these devices.

Due to the greater ease of manufacture compared to other polytypes, 4H-SiC is commonly used as a substrate. However, the band gap of 4H-SiC is greater (3.2 eV) than the corresponding band gap of 3C-SiC (2.3 eV) or Silicon (1.12 eV), making 4H-SiC less attractive to some electronic applications compared to 3C-SiC or compared to Silicon. For example, in the case of Schottky barrier diodes, the possibility of controlling the SBH value is an important aspect in order to reduce energy consumption and minimize conduction losses.

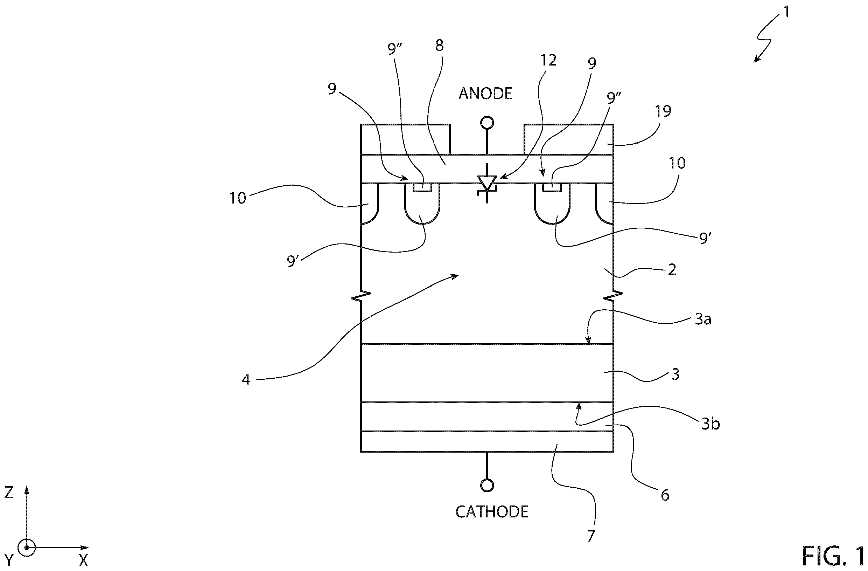

Figure 1 shows, in lateral sectional view in a Cartesian (triaxial) reference system of axes X, Y, Z, a JBS (similarly MPS) device, identified with the reference number 1. Hereinafter reference will be made to a JBS device 1 without thereby losing generality.

The JBS device 1 includes: a substrate 3, of N-type doped 4H-SiC, having a first dopant concentration (e.g., comprised between 1·10¹⁹ and 1·10²² atoms/cm³), resistivity comprised for example between 2 mΩ·cm and 40 mΩ·cm, provided with a surface 3a opposite to a surface 3b, and a thickness comprised between 50 µm and 350 pm, more particularly between 160 µm and 200 pm, for example equal to 180 µm; a drift layer (epitaxially grown) 2, of N-type 4H-SiC, having a second dopant concentration lower than the first dopant concentration (for example comprised between 1·10¹⁴ and 5·10¹⁶ atoms/cm³), which extends on the surface 3a of the substrate 3, and a thickness comprised between 5 and 15 pm; an ohmic contact region 6 (for example of Nickel Silicide), which extends on the surface 3b of the substrate 3; a cathode metallization 7, for example of Ti/NiV/Ag or Ti/NiV/Au, which extends on the ohmic contact region 6; an anode metallization 8, for example including a stack of Ti and AlSiCu, or Ni and AlSiCu, or Mo and AlSiCu, which extends on an upper surface 2a of the drift layer 2; a passivation layer 19 on the anode metallization 8, to protect the latter; a plurality of Junction-Barrier (JB) elements 9 in the drift layer 2, facing the upper surface 2a of the drift layer 2 and which include each a respective implanted region 9' of P-type and an ohmic contact 9"; and an edge termination region, or protection ring, 10 (optional), in particular a P-type implanted region, which surrounds (completely or partially, according to the design options) the JB elements 9.

Schottky diodes 12 are formed at the interface between the drift layer 2 and the anode metallization 8. In particular, Schottky junctions (semiconductor-metal) are formed by portions of the drift layer 2 in direct electrical contact with respective portions of the anode metallization 8.

The region of the JBS device 1 which includes the JB elements 9 and the Schottky diodes 12 (i.e., the region contained within the protection ring 10) is an active area 4 of the JBS device 1.

The variables involved in the formation of the Schottky barrier are many, including the choice of the metal in contact with the surface 2a of the drift layer 2 and its evolution in the formation of the contact, with particular reference to the annealing step. Several studies have analyzed the electrical properties of various metallization patterns for Schottky contacts on 4H-SiC, with particular attention to the value of the Schottky barrier height and to the mechanisms of current transport through the metal/semiconductor interfaces. However, some technological questions are still open and deserve further investigation. For example, the possibility of controlling and lowering the Schottky barrier height is an important point to reduce the energy consumption of the device. Currently, one of the most used metals as a Schottky barrier for 4HSiC-based rectifiers is, as mentioned above, Titanium, which generally provides barrier height values of the order of 1.25 eV. Molybdenum provides similar performances. However, since a further reduction of conduction losses is strongly desired in many applications, reducing the barrier height is one of the current challenges.

US2017/170280A1 relates to a method and an apparatus for manufacturing a semiconductor element that is for forming an ohmic electrode on a silicon carbide (SiC) substrate, and the semiconductor element.

US2022/406948A1 relates to a silicon carbide semiconductor device and a method of manufacturing a silicon carbide semiconductor device.

US2022/384662A1 relates to a semiconductor merged-PN-Schottky (MPS) diode with reduced current-crowding effect and a manufacturing method thereof.

US2021/143272A1 relates to manufacturing a semiconductor device by preventing precipitation of an oxide to prevent peeling of a resin layer.

JP2014063948A relates to a method of manufacturing a silicon carbide semiconductor device, and more particularly, to a method of manufacturing a silicon carbide semiconductor device capable of suppressing the surface roughness of a silicon carbide substrate.

However, the above-mentioned issues are not solved.

### Summary of the invention

The aim of the present invention is to provide a method of forming a metal-semiconductor contact, and an electronic device including the metal-semiconductor contact, such as to overcome the drawbacks of the prior art, and in particular a method which allows the SBH value to be reduced.

According to the present invention, a method of manufacturing an electronic device and an electronic device are provided, as defined in the attached claims.

### Brief description of the drawings

For a better understanding of the present invention, preferred embodiments thereof are now described, purely by way of non-limiting example, with reference to the attached drawings, wherein:
- Figure 1 shows, in cross-sectional view, a JBS or MPS device according to an embodiment which is not the subject matter of the present invention;
- Figures 2A-2E show, in cross-sectional view, manufacturing steps of a JBS or MPS device, with particular reference to the manufacturing of a metal-semiconductor contact of such device, according to an embodiment of the present invention;
- Figure 3 shows, in cross-sectional view, a JBS or MPS device according to an embodiment of the present invention.

### Detailed description of embodiments of the invention

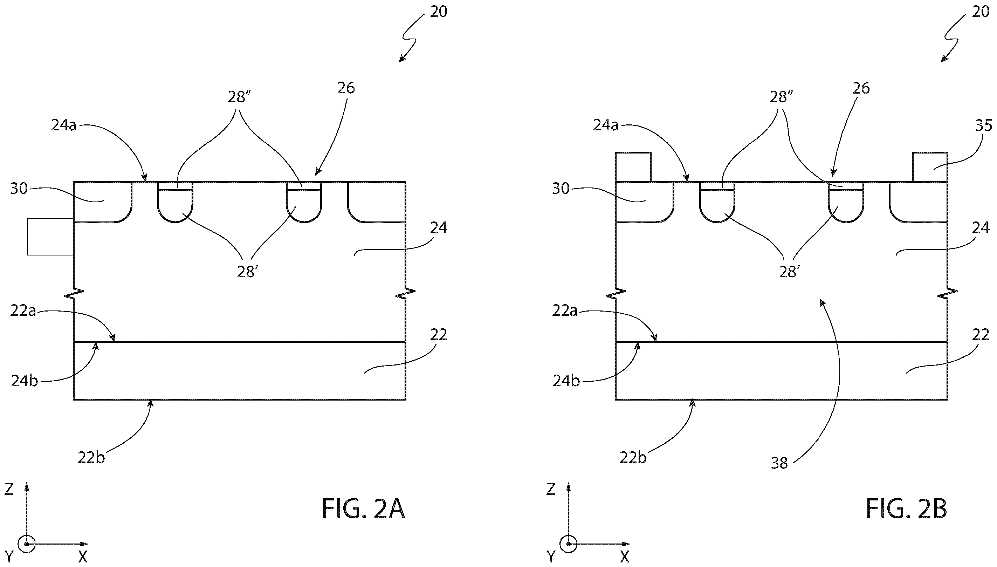

A method of manufacturing an electronic device 20, in particular of JBS type, is now described, according to an embodiment of the present invention and with reference to Figures 2A-2E. Figures 2A-2E illustrate the electronic device 20 in a triaxial system of axes X, Y, Z orthogonal to each other.

With reference to Figure 2A, the electronic device 20 (in particular a JBS device) is illustrated in an intermediate manufacturing step. The device 20 comprises a substrate 22 of semiconductor material, in particular silicon carbide 4H-SiC. However, the present invention also finds application for other SiC polytypes such as for example the cubic polytype (3C-SiC), the hexagonal polytype (6H-SiC) and the rhombohedral polytype (15R-SiC).

The substrate 22 is doped by doping species having a first electrical conductivity (in particular of N-type). The substrate 22 has a dopant concentration for example between 1·10¹⁹ and 1·10²² atoms/cm³ (boundaries included) and a resistivity for example between 2 mΩ·cm and 40 mΩ·cm (boundaries included). The substrate 22 has an upper surface 22a opposite to a lower surface 22b along the direction Z, and a thickness (along the direction Z) comprised between 50 µm and 350 pm, more particularly between 160 µm and 200 pm, for example equal to 180 µm.

The device 20 further comprises a drift layer (e.g., epitaxially grown) 24, here in particular of N-type 4H-SiC (similarly, it may be of 3C-SiC, 6H-SiC, 15H-SiC or other SiC polytypes). The drift layer 24 extends on the surface 22a of the substrate 22 and has an own upper surface 24a opposite, along the direction Z, to a lower surface 24b; the lower surface 24b of the drift layer is in contact with the upper surface 22a of the substrate 22. The drift layer 24 has a dopant concentration lower than the dopant concentration of the substrate 22 (for example between 1·10¹⁴ and 5·10¹⁶ atoms/cm³ - boundaries included). The drift layer 24 has a thickness (along the direction Z) comprised between 3 and 30 µm.

The substrate 22 and the drift layer 24 form, as a whole, a solid body of semiconductor material, in particular of SiC. Furthermore, it becomes apparent that one or more further semiconductor layers may be present between the substrate 22 and the drift layer 24; alternatively, the drift layer 24 may be absent: in this case, the steps described hereinbelow apply to the substrate 22.

The device 20 further comprises a plurality of Junction-Barrier (JB) elements 26 in the drift layer 24, facing the upper surface 24a of the drift layer 24 and each including a respective implanted region 28' having a second conductivity (here of P-type) opposite to the first conductivity; an ohmic contact 28" is also present, in a per se known manner, at each implanted region 28'.

The device 20 further comprises, optionally, an edge termination region, or protection ring, 30. The edge termination region 30 is in particular an implanted region having the second conductivity (P-type) and surrounds (completely or partially) the JB elements 26.

With reference to Figure 2B, a hard mask 35 is formed on the surface 24a of the drift layer 24, lateral to the JB elements 26 and surrounding the JB elements 26, and only partially superimposed on the edge termination region 30 where present. The hard mask 35 is for example of silicon oxide (SiO₂).

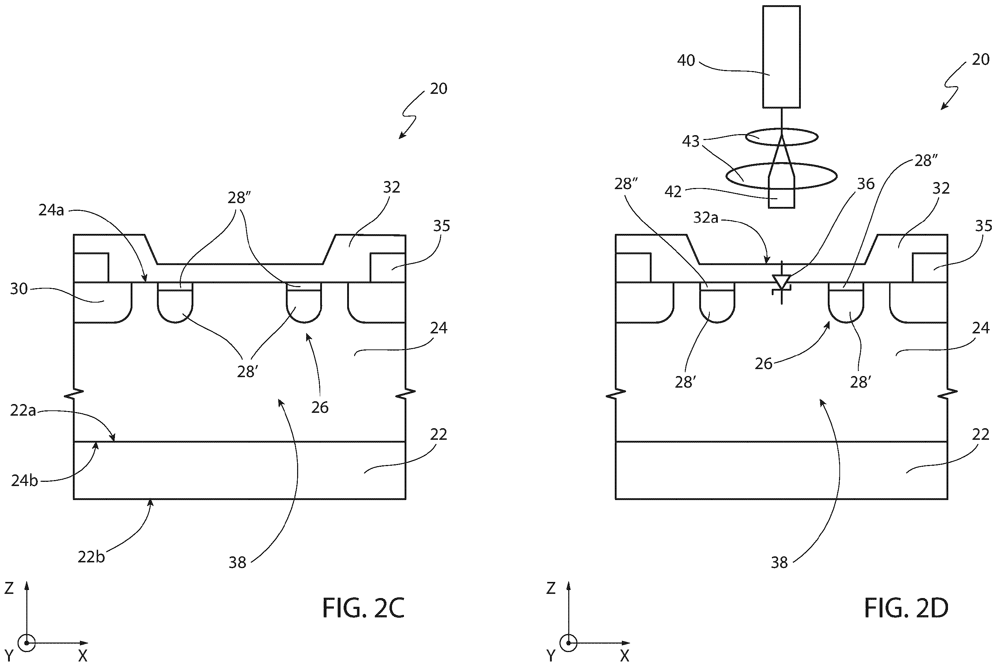

Then, Figure 2C, an electrically conductive layer 32 of metal material, in particular of Titanium or Titanium Nitride (TiN), or other metals and related nitrides (e.g., Mo, MoN), is formed on the upper surface 24a of the drift layer 24 and on the hard mask 35.

The conductive layer 32 is formed for example by deposition of Titanium or Titanium Nitride. In particular, the electrically conductive layer 32 (e.g., of TiN) is deposited by a sputtering process reactive in an N₂ and Ar atmosphere. The percentage of N₂ in the gaseous mixture may vary between 0% (in this case a metal Ti layer is deposited, rather than a TiN layer) and 900. In particular, in a non-limiting embodiment, the percentage of N₂ in the gaseous mixture is about 75%.

The conductive layer 32 has a thickness, along the direction Z, comprised between 10 and 100 nm (boundaries included).

The conductive layer 32 has an exposed upper surface 32a, for a subsequent manufacturing step described with reference to Figure 2D.

The conductive layer 32 extends in electrical contact with the JB elements 26 and with the drift layer 24, forming a Schottky contact (metal-semiconductor junction) with the drift layer 24 and, consequently, forming a respective Schottky diode 36. The region of the device 20 which includes the JB elements 26 and the Schottky contact (i.e., the region contained within the protection ring 30, if present) is an active area 38 of the device 20.

Therefore, Figure 2D, the present invention provides an annealing step of the conductive layer 32 with the aim of adjusting the barrier height (SBH) of the Schottky contact formed at the step of Figure 2C. According to one aspect of the invention, the annealing occurs using a LASER source 40 (e.g., excimer LASER) configured to emit a beam 42.

The configuration and operating parameters of the LASER source 40 are the following (boundaries of the ranges included):
- wavelength between 290 nm and 370 nm, in particular equal to 308 nm;
- duration of the pulse between 100 ns and 300 ns, in particular 160 ns;
- number of pulses between 1 and 5, in particular 2;
- energy density between 1 and 3 J/cm², in particular 2 J/cm² (considered at the level of the upper surface 32a of the conductive layer 32).

The area of the spot of the beam 42, at the level of the surface of the conductive layer 32, is, for example, comprised between 0.7 and 2.25 cm². Such a spot area value may be obtained, for example, by the aid of suitable focusing lenses 43, in a per se known manner.

The LASER beam is, in one embodiment, oriented along the direction Z; in other words, it reaches the upper surface 32a of the conductive layer 32 orthogonally to this surface 32a. However, it becomes apparent that, in other embodiments, the LASER beam may have a different orientation, for example it may form an angle with the direction Z (similarly, an angle with the portion of the surface 32a of the conductive layer 32 on which it impinges).

Using the aforementioned parameters, the conductive layer 32 is heated uniformly (both orthogonally to the beam, along the directions X and Y, and longitudinally to the beam, along the direction Z). The annealing temperature reached at the level of the surface 32a of the conductive layer 32 is in particular comprised between 1800 and 3000 °C.

It becomes apparent that the surface 32a of the conductive layer 32 may be covered by a further layer (e.g., a protective layer or a further conductive layer, for example a carbonaceous or carbon-containing layer or a multilayer including carbon) provided that this further layer does not affect the annealing step previously described.

The annealing step described allows the SBH value to be adjusted, in particular it allows the SBH value to be reduced in a manner that is controlled, rapid and easily integrable into a production process.

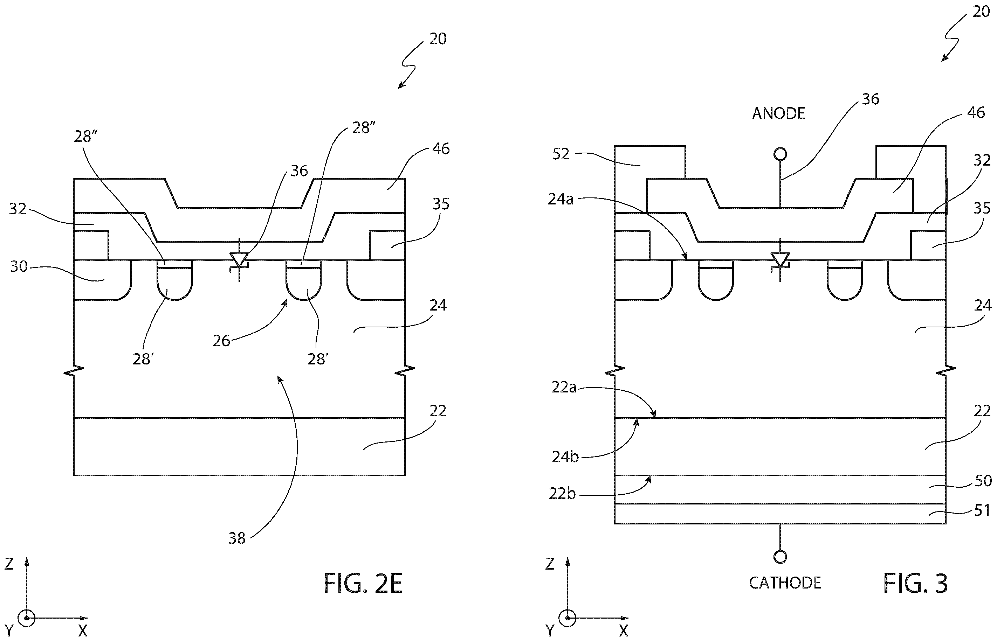

Then, Figure 2E, the method proceeds with the formation of a further conductive layer 46 (anode terminal) above, and in electrical contact with, the conductive layer 32. This further conductive layer 46 is for example of metal material, such as Al or Al alloys such as AlCu or AlSiCu, and is formed by Physical Vapor Deposition (PVD), in particular sputtering, at a temperature comprised between 200°C and 500°C, in particular 400°C. The conductive layer 46 has for example a thickness between 3 and 5 µm (boundaries included). The Applicant has verified that deposition temperature values outside the above-mentioned range result in poor stiction between the conductive layers 32 and 46.

The conductive layer 46 (optional) improves contact with the package. AlSiCu, in particular, is suitable for the wire bonding process. Furthermore, the proposed solution ensures the current flow through a layer having low resistance (due both to the thickness, normally in the range between 3 and 5 pm, and to the low resistivity of the material).

In a manner not illustrated in Figures 2A-2E, the manufacturing process described may also provide steps of forming a cathode electrical terminal at the lower surface 22b of the substrate 22, for example including an ohmic contact (e.g., nickel silicide) 50 on the lower surface 22b and a metallization on the ohmic contact 51 (illustrated in Figure 3).

Furthermore, the manufacturing method may further comprise a step of removing selective portions of the conductive layers 32 and 46, in order to remove such layers from regions of the device 20 wherein they do not have a function. Furthermore, the method may comprise a step of forming a passivation layer 52 (illustrated in Figure 3), to protect the device 20. The passivation layer extends above the conductive layer 46, except for portions of the conductive layer 46 used during subsequent steps of forming electrical contacts through bonding (e.g., wire bonding).

Figure 3 shows, in a lateral sectional view in the Cartesian (triaxial) reference system of axes X, Y, Z of Figures 2A-2E, the device 20 (JBS diode), according to an embodiment of the present invention. The view of Figure 3 may similarly relate to an MPS (diode) device (hereinafter reference will exclusively be made to a JBS device without thereby losing generality).

The JBS device 20 includes: the substrate 22, of N-type 4H-SiC, having the first dopant concentration; the (epitaxial) drift layer 24, of N-type 4H-SiC, having the second dopant concentration; the conductive layer 32 on the surface 24a; the conductive layer 46 on the conductive layer 32; a cathode terminal 50 on the back of the substrate 22.

The drift layer 24 comprises, as already described with reference to Figure 2A, the plurality of implanted regions 26, facing the upper surface 24a of the drift layer 24, at the interface with the conductive layer 32. Figure 3 also illustrates the ohmic contacts 28", extending at the (P-type) implanted regions 28' and forming, with the latter, respective JB elements 26.

The edge termination region, or protection ring, 30 (optional), in particular a P-type implanted region, completely or partially surrounds the JB elements 26.

One or more Schottky diodes 36 extend at the interface between the conductive layer 32 and the drift layer 24, laterally to the implanted regions 26. In particular, one or more Schottky junctions (semiconductor-metal) are formed by portions of the conductive layer 32 in direct electrical contact with respective portions of the drift layer 24.

The region of the JBS device 20 which includes the JB elements 26 and the Schottky diodes 36 (i.e., the region contained within the protection ring 30, when present) is the active area 38 of the JBS device 20.

From an examination of the characteristics of the invention provided according to the present description, the advantages that it affords are evident.

Finally, it is clear that modifications and variations may be made to what has been described and illustrated herein, without thereby departing from the scope of the present invention, as defined in the attached claims.

In particular, the present invention is not limited to the manufacturing of SiC JBS or MPS devices, but extends to the generic formation of a metal-semiconductor contact (Schottky contact).

## Claims

1. A method of forming a metal-semiconductor Schottky contact, comprising the steps of:
forming, on a semiconductor body (22, 24) having a first electrical conductivity (N), a first metal layer (32);
performing a thermal treatment of at least one portion of the first metal layer (32) by a LASER beam (42) having an incidence direction (Z) on the first metal layer (32), including heating said portion of the first metal layer (32), along said incidence direction, at a temperature between 1500 °C and 3000 °C.

2. The method according to claim 1, wherein performing the thermal treatment comprises performing one or more scans of said portion of the first metal layer (32) by said LASER beam (42).

3. The method according to claim 1 or 2, wherein said incidence direction (Z) is transverse to a surface (32a) of the first metal layer (32).

4. The method according to any of the preceding claims, wherein said portion of the first metal layer (32) extends in electrical contact with the semiconductor body.

5. The method according to claim 4, wherein said portion of the first metal layer (32) forms, with the semiconductor body (22, 24), a metal-semiconductor junction, or Schottky junction.

6. The method according to any of the preceding claims, wherein the step of performing the thermal treatment comprises generating the LASER beam (42) with the following parameters:
- wavelength of the LASER beam between 290 and 370 nm;
- duration of the pulse of the LASER beam between 1 ns and 5 ns;
- number of pulses of the LASER beam between 1 and ???; and
- energy density of the LASER beam between 1 and 3 J/cm².

7. The method according to claim 6, wherein each pulse of the LASER beam (42) impinges on a surface (32a) of the conductive layer (32) having an area comprised between 0.7 and 2.25 cm².

8. The method according to claim 6 or 7, wherein the wavelength of the LASER beam is equal to 308 nm, the duration of the pulse of the LASER beam is equal to 160 ns; the number of pulses of the LASER beam is between 1 and 5; and the energy density of the LASER beam is between 1 and 3 J/cm².

9. The method according to any of the preceding claims, wherein said thermal treatment is configured to generate uniform heating of said portion of the first metal layer (32) along said incidence direction.

10. The method according to any of the preceding claims, wherein the first metal layer (32) is of a material among: Ti, TiN, Mo, MoN.

11. The method according to any of the preceding claims, wherein the first metal layer (32) has a thickness between 10 nm and 100 nm.

12. The method according to any of the preceding claims, further comprising, after the step of performing the thermal treatment, the step of forming a second metal layer (46) on the first metal layer (32),
said step of forming the second metal layer (46) comprising depositing Al or Al alloys, including AlCu or AlSiCu, having a thickness comprised between 3 and 5 µm.

13. The method according to any of the preceding claims, wherein the semiconductor body (22, 24) is of silicon carbide, SiC, in particular 4H-SiC.

14. A method of manufacturing an electronic device, comprising forming a metal-semiconductor contact according to any of claims 1-13.

15. An electronic device (20), comprising:
- a solid body (22, 24), in particular of SiC, having a first electrical conductivity (N);
- at least one implanted region (28') having a second electrical conductivity (P) opposite to the first electrical conductivity (N) extending at a front side (24a) of the solid body (22, 24);
- a first metal layer (32) on the front side (24a), in electrical contact with the solid body (22, 24) at the front side (24a), having a thickness between 10 nm and 100 nm and of a material among Ti, TiN, Mo, MoN;
- a second metal layer (46) on the first metal layer (32) and in direct electrical contact with the first metal layer, of a material among: Al or Al alloys, including AlCu or AlSiCu, having a thickness comprised between 3 and 5 µm.
